# FASCICULE DE BREVET EUROPEEN

(11) **EP 3 026 712 B1**
(45) Date de publication et mention de la délivrance du brevet: **15.07.2020**
(21) Numéro de dépôt: 15196105.9
(22) Date de dépôt: 24.11.2015
(51) Int. Cl.: H01L 29/78, H01L 21/336, H01L 21/8238, H01L 29/51

(54) **PROCEDE AMELIORE DE MISE EN CONTRAINTE D'UNE ZONE DE CANAL DE TRANSISTOR**
VERBESSERTES VERFAHREN ZUR SPANNUNGSINDUKTION EINER TRANSISTORKANALZONE
IMPROVED METHOD FOR STRAINING A REGION OF A TRANSISTOR CHANNEL

(30) Priorité: 25.11.2014 FR 1461429
(43) Date de publication de la demande: 01.06.2016
(73) Titulaire: Commissariat à l'Énergie Atomique et aux Énergies Alternatives, 75015 Paris (FR)
(72) Inventeur: REBOH, Shay, 38054 Grenoble (FR); MATHIEU, Benoît, 38000 Grenoble (FR)
(74) Mandataire: Brevalex

(56) Documents cités:
- US-A1- 2005 153 486
- US-A1- 2007 202 663
- US-A1- 2009 186 455
- US-A1- 2010 109 091
- US-A1- 2014 256 109

## Description

### DOMAINE TECHNIQUE ET ART ANTÉRIEUR

La présente description concerne le domaine des structures de transistors, et plus particulièrement celles dotées d'une zone de canal subissant une déformation ou contrainte mécanique.

Par déformation mécanique on entend un matériau qui a son ou ses paramètre(s) de maille cristalline allongé(s) ou écourté(s).

Dans le cas où le paramètre de maille déformé est plus important que le paramètre dit *« naturel »* d'un matériau cristallin, celui-ci est dit en déformation en tension. Lorsque le paramètre de maille déformé est plus petit que le paramètre de maille naturel, le matériau est dit en déformation compressive ou en compression.

A ces états de déformation mécanique, on associe des états de contraintes mécaniques. Pour autant, il est également commun de se référer à ces états de déformation comme des états de contraintes mécaniques. Dans la suite de la présente demande, cette notion de déformation (« *strain »* selon la terminologie anglo-saxonne) sera désignée de façon générique par le terme *« contrainte ».*

Une contrainte appliquée à un matériau semi-conducteur induit une modification de la maille cristalline et donc de sa structure de bande, dont va découler une modification de la mobilité des porteurs de charge dans ce matériau.

La mobilité des électrons est augmentée (respectivement diminuée) par une contrainte en tension (respectivement en compression) du matériau semi-conducteur dans lequel ils transitent alors que la mobilité des trous sera augmentée (respectivement diminuée) lorsque le semi-conducteur est en compression (respectivement en tension).

Pour générer une contrainte dans le canal d'un transistor, des techniques dites de mémorisation de contrainte ou SMT (pour *« Stress Memorization Technique »*) ont été développées.

Un exemple d'une telle méthode est évoquée dans le document : « Novel Stress Memorization Technology (SMT) for High Electron Mobility Enhancement of Gate Last High-k/Metal Gate Devices », de Lim et al. IEEE 2010, ou encore dans le document « Strain mapping of Si devices with stress memorization processing », de Wang et al. Applied Physics Letters 103 (2013).

Cette méthode comprend notamment des étapes d'amorphisation et de recristallisation afin de créer des dislocations génératrices de contraintes dans un matériau semi-conducteur.

Les documents :
- "Novel Locally Strained Channel Technique for High Performance 55nm CMOS", de Ota et al., IEDM Tech. Dig., 2002 ;
- "Stress Memorization in High-Performance FDSOI Devices with Ultra-Thin Silicon Channels and 25nm Gate Lengths", de Singh et al., IEDM, 2005 ;
- "Mechanism of Stress Memorization Technique (SMT) and Method to Maximize Its Effect", de Pandey, et al., IEEE ELECTRON DEVICE LETTERS, VOL. 32, NO. 4, 2011, présentent d'autres méthodes de mémorisation de contrainte dans une zone semi-conductrice de canal d'un transistor.

Le document US 2014/0256109 A1 présente un procédé de réalisation d'un transistor à canal contraint comprenant la formation d'une couche de contrainte sur un bloc de grille sacrificielle, puis la mémorisation de la contrainte dans le canal à l'aide d'un recuit puis retrait de la couche de contrainte. Ensuite la grille sacrificielle est remplacée par une autre grille.

Le document US 2007/202663 divulgue un procédé de gestion de la contrainte dans un circuit intégré.

Il se pose le problème de trouver un nouveau procédé de mise en contrainte d'une zone semi-conductrice de canal de transistor.

### EXPOSÉ DE L'INVENTION

La présente invention concerne un procédé selon les termes de la revendication 1.

La présente invention concerne notamment un procédé de mise en contrainte d'une zone semi-conductrice destinée à former un canal de transistor comprenant des étapes consistant à :
a) former un ou plusieurs blocs de contrainte à base d'un matériau ayant une contrainte intrinsèque autour d'une zone à base d'un matériau semi-conducteur dans laquelle un canal d'un transistor est destiné à être réalisé et sur laquelle une grille du transistor est destinée à être formée, le ou les blocs de contrainte étant agencés de manière à induire une contrainte donnée dans cette zone,
b) former sur cette zone semi-conductrice un bloc de grille comprenant au moins un matériau de diélectrique déposé sur le matériau semi-conducteur,
c) retirer au moins partiellement le ou les blocs de contrainte.

Le bloc de grille est choisi à l'étape b) avec un module d'Young et une épaisseur de sorte que lorsque les blocs de contrainte sont au moins partiellement retirés à l'étape c), la contrainte donnée est au moins partiellement conservée dans la zone de canal.

On fige ou on mémorise ainsi la contrainte induite initialement par les blocs de contrainte dans la zone semi-conductrice.

Dans un procédé suivant l'invention, les blocs de contrainte permettent à l'étape b) de définir un emplacement pour la grille ce qui permet une réalisation plus aisée de la grille. Ainsi, les blocs de contrainte ont ainsi une fonction supplémentaire, celle de permettre un positionnement plus précis de la grille.

Le bloc de grille comprend au moins un matériau de diélectrique formé sur la zone semi-conductrice. Le matériau diélectrique de grille est avantageusement choisi de sorte à avoir un module d'Young élevé et en particulier plus élevé que celui du matériau semi-conducteur de la zone semi-conductrice dans laquelle le canal est prévu.

A épaisseur donnée, le fait de prévoir un matériau diélectrique de grille de module d'Young élevé, permet d'améliorer la conservation de contrainte dans la zone de canal une fois que les blocs de contrainte sont au moins partiellement retirés.

Le matériau diélectrique de grille à module d'Young élevé peut être un matériau de type High-k, tel que du HfO₂ ou du Al₂O₃ ou du HfSiOₓN_{y}.

On choisit de préférence le matériau de grille situé sur le diélectrique de grille selon des critères identiques, avec un module d'Young élevé et en particulier plus élevé que celui du matériau semi-conducteur de la zone semi-conductrice dans laquelle le canal est prévu.

Selon une possibilité de mise en œuvre, préalablement à l'étape a), on peut former sur ladite zone semi-conductrice une grille sacrificielle, le ou les blocs de contrainte réalisés à l'étape a) étant disposés contre cette grille sacrificielle, le procédé comprenant en outre après l'étape a) et préalablement à l'étape b) une étape consistant à retirer la grille sacrificielle.

La grille sacrificielle permet notamment un positionnement plus aisé des blocs de contrainte.

Préalablement au retrait de la grille sacrificielle, on peut effectuer un recuit thermique, en particulier à haute température, de manière à permettre une expansion de la grille sacrificielle.

Selon une possibilité de mise en œuvre du procédé, après l'étape c) on peut mettre en œuvre des étapes consistant à :
- déposer à nouveau une couche à base d'un matériau de contrainte ayant une contrainte élastique intrinsèque, puis
- effectuer un recuit thermique.

Dans un cas où le matériau de contrainte est un matériau diélectrique, le procédé peut comprendre en outre la formation d'espaceurs isolants pour la grille du transistor dans le matériau de contrainte diélectrique.

Selon une possibilité de mise en œuvre du procédé, on prévoit la zone semi-conductrice de canal dans une région d'une couche superficielle d'un substrat délimitée par une ou plusieurs tranchées remplies de matériau isolant et/ou sur une couche de matériau isolant.

Dans ce cas, le procédé peut comprendre en outre, après l'étape b), une étape de recuit thermique de manière faire fluer le matériau isolant.

Le procédé peut s'appliquer à un substrat de type semi-conducteur sur isolant. Dans ce cas, la zone semi-conductrice peut être située dans une couche superficielle du substrat et reposer sur une couche isolante du substrat semi-conducteur sur isolant.

Le procédé peut s'appliquer à la réalisation de transistors planaires.

Selon une possibilité de mise en œuvre particulière du procédé, le transistor peut être de type finFET, la zone semi-conductrice étant dans ce cas prévue dans un barreau semi-conducteur.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1J illustrent un premier exemple de procédé suivant l'invention permettant de mémoriser une contrainte dans une zone semi-conductrice de canal de transistor,
- les figures 2A-2B illustrent une réalisation d'espaceurs isolants par gravure d'une couche de mise en contrainte susceptible d'être mise en œuvre lors d'un procédé suivant l'invention,

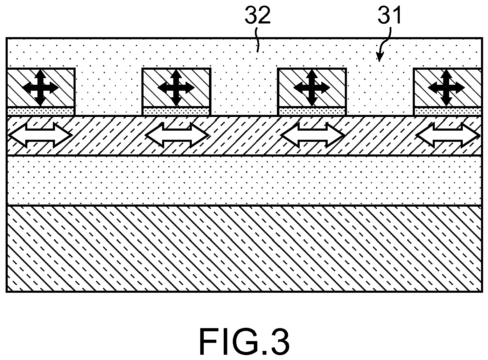

- la figure 3 illustre une variante de procédé suivant l'invention,
- la figure 4 illustre une étape de dépôt supplémentaire d'une couche de contrainte lors d'un procédé suivant l'invention,
- les figures 5A-5E illustrent un exemple de procédé suivant l'invention permettant de mémoriser une contrainte dans une zone semi-conductrice de canal de transistor entourée par des tranchées isolantes,
- les figures 6A-6F illustrent une variante de procédé suivant l'invention permettant de mémoriser une contrainte dans une zone semi-conductrice de canal d'un transistor finFET,
- la figure 7 donne un diagramme reprenant des étapes du premier exemple de procédé suivant l'invention et de variantes de cet exemple de procédé,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation, telle que *« sous », « sur », « au-dessus », « supérieure », « latéraux* » etc. d'une structure s'appliquent en considérant que la structure est orientée de la façon illustrée sur les figures.

### EXPOSÉ DÉTAILLÉ DE MODES DE RÉALISATION PARTICULIERS

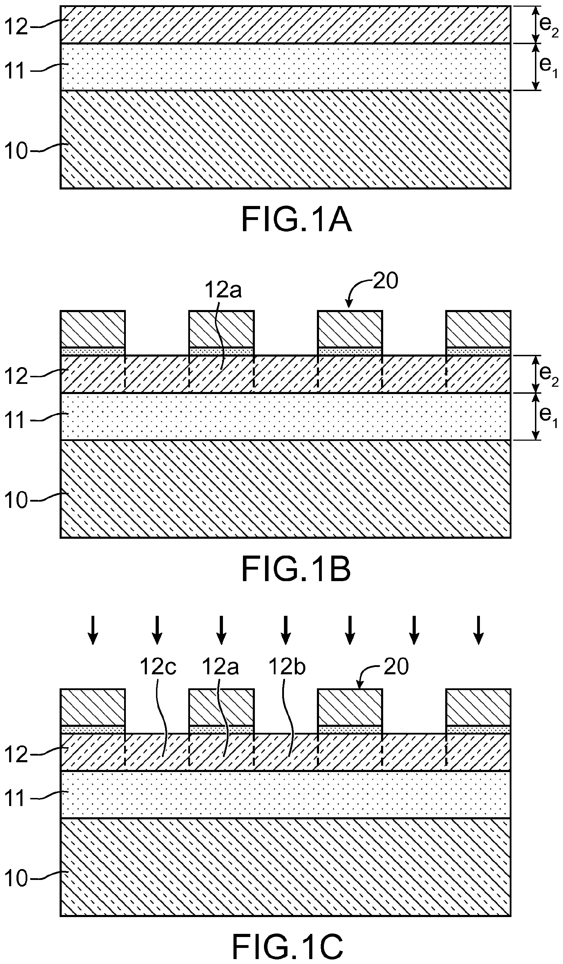

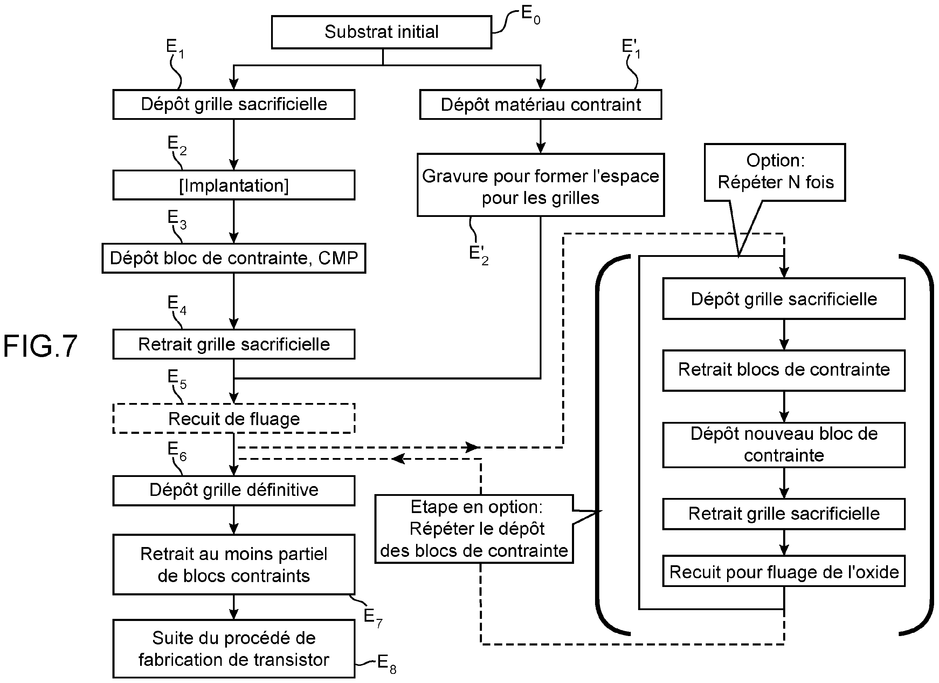

Un premier exemple de procédé permettant de réaliser une mise en contrainte d'au moins une zone semi-conductrice de canal de transistor va être décrit en liaison avec les figures 1A-1I et la figure 7 sur laquelle les principales étapes de cet exemple de procédé sont données.

Le matériau de départ pour ce procédé (étape E₀ du diagramme de la figure 7) peut être un substrat de type semi-conducteur sur isolant, par exemple de type SOI (SOI pour *« silicon on insulator »* ou *« silicium sur isolant »*)*.*

Le substrat comprend ainsi une couche de support 10 semi-conductrice, par exemple à base Si, ainsi qu'une couche isolante 11, par exemple à base de SiO₂, située sur et en contact avec la couche de support 10. La couche isolante 11 peut être par exemple de type BOX (BOX *pour « Buried Oxide »*) et avoir une épaisseur e₁ qui peut être par exemple comprise entre 10 nm et 100 nm. Le substrat comprend en outre une couche semi conductrice 12 dite *« superficielle »,* par exemple à base de Si, disposée sur et en contact avec ladite couche isolante 11. Cette couche semi-conductrice superficielle 12 peut avoir une épaisseur e₂ par exemple comprise entre 5 nm et 50 nm (figure 1A).

On forme tout d'abord au moins un bloc 20 de grille sacrificielle (figure 1B et étape E1 sur figure 7) en regard d'une zone 12a de la couche semi-conductrice superficielle 12, dans laquelle un canal de transistor est destiné à être réalisé. Le bloc 20 de grille sacrificielle peut être formé tout d'abord par dépôt d'un empilement comprenant une couche de matériau diélectrique de grille tel que par exemple du SiO₂, ayant une épaisseur par exemple de l'ordre de 1 à 2 nm, puis d'une couche de matériau de grille tel que par exemple du polySi, ayant une épaisseur qui peut être comprise entre 40 et 80 nm, par exemple de l'ordre de 50 nm. Ensuite, des étapes de photolithographie puis de gravure peuvent être mises en œuvre afin de définir un ou plusieurs blocs de grille(s) sacrificiel(les).

On peut ensuite réaliser un dopage (figure 1C et étape E2 sur figure 7), par exemple par implantation ionique de régions 12b, 12c de la couche semi-conductrice sacrificielle 12 qui ne sont pas protégées par le bloc 20 de grille sacrificiel et sont destinées à former respectivement une région de source et une région de drain du transistor, de part et d'autre de la zone 12a destinée à former un canal.

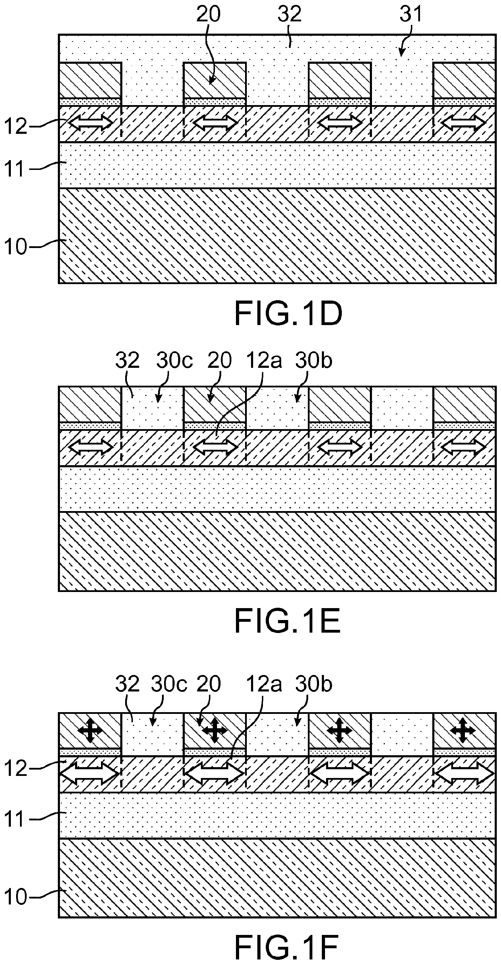

Puis, on forme une couche 31 de mise en contrainte destinée à induire dans la couche superficielle 12 du substrat un type de contrainte donnée (figure 1D et étape E3 sur figure 7). La couche 31 de mise en contrainte est déposée de manière à recouvrir notamment le bloc 20 de grille sacrificiel et la couche semi-conductrice superficielle 12 au niveau des régions 12b, 12c de source et de drain. Cette couche 31 peut être à base d'un matériau 32 tel que par exemple du nitrure de silicium (SiₓN_{y}) ayant une contrainte élastique intrinsèque en tension ou en compression. Une couche de nitrure de silicium d'épaisseur par exemple comprise entre 20 et 150 nm, par exemple de l'ordre de 80 nm et de contrainte en tension de l'ordre de 1.5 GPa peut être formée par exemple dans le cas où le transistor dont on souhaite contraindre le canal est de type NMOS. Une couche de nitrure de silicium ayant une contrainte intrinsèque en compression de l'ordre de 1.5 GPa peut être formée par exemple dans le cas où l'on souhaite contraindre le canal d'un transistor PMOS.

Ensuite, on peut retirer une épaisseur de la couche 31 de mise en contrainte située au-dessus de la face supérieure du bloc 20 sacrificiel (figure 1E et suite de l'étape E3 sur figure 7). Ce retrait peut être réalisé par le biais d'une planarisation ou d'un polissage mécano chimique (CMP pour « Chemical Mechanical Planarization ») jusqu'à atteindre la face supérieure du bloc sacrificiel. On forme ainsi des blocs 30c, 30b à base d'un matériau contraint 32 disposés de part et d'autre du bloc 20 de grille sacrificiel et qui sont agencés contre des flancs latéraux de ce bloc 20.

On peut ensuite avantageusement réaliser un recuit thermique à une température qui peut être comprise par exemple entre 900 °C et 1100 °C. Ce recuit peut avoir une durée prévue par exemple entre 1s (spike) et 2 min. Le recuit peut être adapté pour modifier la structure de la grille sacrificielle 10a et provoquer une expansion du matériau de grille, en particulier lorsque celui-ci est du PolySi. Lorsque la contrainte exercée dans la zone 12a de canal est une contrainte en tension, cela peut permettre d'amplifier cette contrainte (figure 1F). Un tel recuit peut en variante être réalisé avant l'étape de polissage CMP.

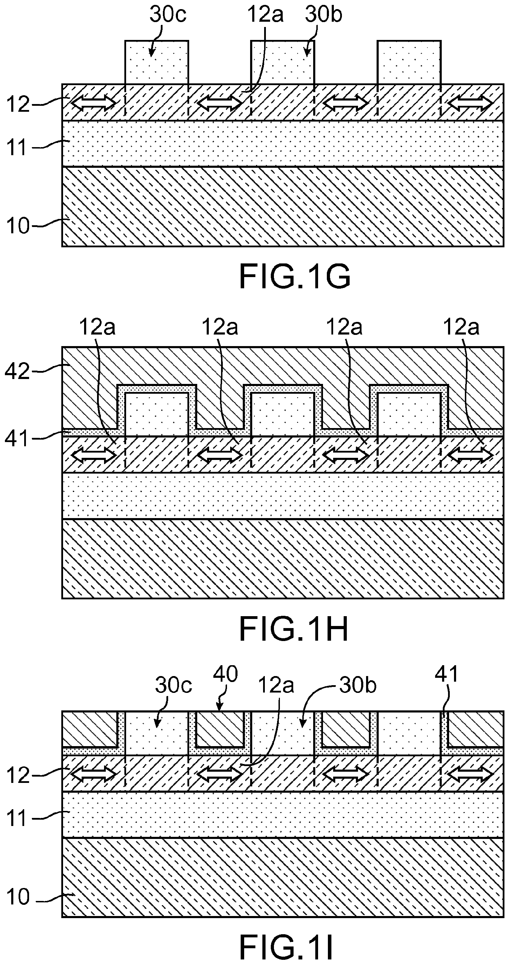

Puis, on effectue un retrait du bloc 20 de grille sacrificiel (figure 1G et étape E4 sur figure 7). Ce retrait peut être réalisé par gravure(s) sélective(s) de l'empilement de grille vis-à-vis du matériau contraint 32. Par exemple, dans le cas où le matériau de grille sacrificiel est du polysilicium tandis que le matériau contraint 32 est du SiₓN_{y}, une gravure du polysilicium à l'aide d'une solution à base d'acide nitrique (HNO3) + et d'acide fluorhydique (HF) peut être réalisée. Dans le cas où le diélectrique de grille sacrificiel est du SiO₂, une gravure à l'aide de HF peut être ensuite effectuée. Ce retrait permet d'augmenter la déformation engendrée dans la zone 12a destinée à former un canal de la couche semi-conductrice superficielle 12.

On peut ensuite avantageusement réaliser un recuit thermique (étape E5 sur figure 7) pour permettre de faire fluer le matériau de la couche 11 par exemple à base d'oxyde de silicium. Ce recuit peut être réalisé à une température par exemple comprise entre 1000°C et 1250°C pour une durée comprise par exemple entre 1 et 10 minutes.

Ensuite (figure 1H et étape E6 sur figure 7), on dépose un nouveau bloc de grille, en particulier sur la zone 12a destinée à former un canal. Ce bloc de grille est formé d'un empilement comprenant un matériau diélectrique 41 disposé en contact avec la couche superficielle et les blocs de matériau contraint 32.

On cherche à conserver, autrement dit à « mémoriser » la contrainte induite dans la zone 12a destinée à former un canal. On choisit pour cela le matériau en contact ou à proximité de la zone de canal 12a et son épaisseur. L'effet de mémorisation de contrainte est d'autant plus important que le module d'Young du ou des matériaux du nouveau bloc de grille est important, et que l'épaisseur du ou des matériaux de ce nouveau bloc de grille est importante.

Le matériau diélectrique 41 qui se trouve en contact avec la zone de canal 12a est choisi pour une épaisseur donnée de sorte à avoir un module d'Young élevé, supérieur à au moins la moitié du module d'Young du matériau semi-conducteur de la couche superficielle et de préférence plus élevé que celui du matériau semi-conducteur de la couche superficielle. Le matériau diélectrique 41 peut avoir par exemple un module d'Young deux fois plus élevé que celui du matériau de la couche semi-conductrice superficielle. Le matériau diélectrique 41 peut être avantageusement un matériau « High-k », dont le module d'Young est généralement plus élevé que celui du matériau semi-conducteur de la couche superficielle 12 et que celui du matériau diélectrique, ici du SiO₂, utilisé précédemment pour l'empilement de grille sacrificielle. Le matériau diélectrique 41 peut être par exemple du HfO₂, ou du Al₂O₃ ou du HfSiOₓN_{y}. Le matériau diélectrique 41 peut avoir une épaisseur par exemple comprise entre 0.5 et 5 nm.

Ensuite, un matériau 42 de grille tel que par exemple du polysilicium ou du TiN est effectué. Le choix du matériau 42 est de préférence dicté par les mêmes critères que pour le diélectrique 41. Ainsi, le matériau 42 de grille est également choisi de préférence de sorte à avoir un module d'Young élevé, et en particulier plus élevé que celui du matériau semi-conducteur de la couche superficielle. Le matériau 42 de grille peut avoir par exemple un module d'Young deux fois plus élevé que celui du matériau de la couche semi-conductrice superficielle. Le matériau 42 de grille peut avoir une épaisseur par exemple comprise entre 10 nm et 100 nm.

Puis, on peut retirer une épaisseur de l'empilement de matériaux 41, 42 situés au-dessus de la face supérieure des blocs 30b, 30c de matériau 32 contraint (figure 1I et suite de l'étape E6 sur figure 7). Ce retrait peut être réalisé par le biais d'une planarisation ou d'un polissage mécano-chimique (CMP) jusqu'à atteindre la face supérieure des blocs 30b, 30c de matériau 32 contraint. On forme ainsi un bloc 40 de grille en regard de la zone 12a de canal.

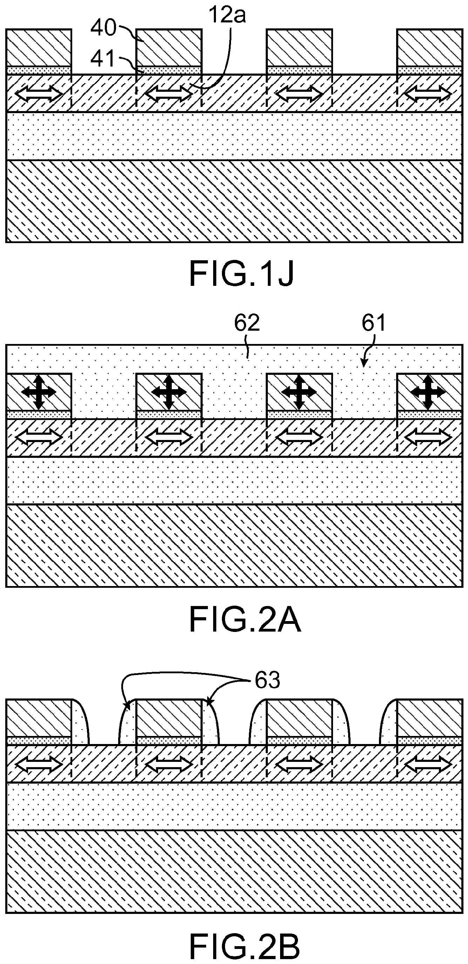

On effectue ensuite un retrait des blocs 30b, 30c de matériau contraint 32 et éventuellement de résidu de matériau diélectrique 41 (figure 1J). Ce retrait peut être effectué par exemple par gravure sélective du matériau contraint 32 vis-à-vis des matériaux de l'empilement de grille. Dans le cas où le matériau contraint 32 est du nitrure de silicium, le retrait peut être réalisé par exemple à l'aide de solution d'acide phosphorique à 85% à une température de l'ordre de 180 °C.

Après avoir effectué un retrait des blocs 30c, 30d de matériau contraint autour du bloc 40 de grille, la contrainte engendrée dans la zone semi-conductrice 12a est au moins partiellement conservée dans la zone 12a de canal. Cette mémorisation de contrainte est permise grâce à l'empilement de grille et notamment au diélectrique 41 de grille choisi, et en particulier à son module d'Young élevé.

Selon une possibilité (non représentée sur la figure 1J), le retrait des blocs 30b, 30c peut être effectué de manière partielle afin de conserver des régions de matériau contraint 32 contre les flancs latéraux du bloc 40 de grille et de sorte à former des espaceurs isolants.

On peut ensuite réaliser des étapes visant à achever la formation du transistor (étapes E8 sur figure 7) et notamment des étapes de formation d'espaceurs isolants contre les flancs latéraux de la grille, de formation de zones de source et de drain, par exemple par croissance de zones semi-conductrices, de réalisation de contacts.

Selon une possibilité de mise en œuvre particulière du premier exemple de procédé, on peut, après avoir effectué le retrait du matériau contraint décrit en liaison avec les figures 1H-1I, déposer à nouveau une couche 61 de matériau 62 ayant une contrainte élastique intrinsèque. Le matériau 62 est un diélectrique tel que par exemple du nitrure de silicium SiₓN_{y} (figure 2A).

On forme ensuite des espaceurs isolants 63 contre le bloc 30 de grille, par gravure du matériau diélectrique contraint 62 (figure 2B).

Selon une variante de mise en œuvre particulière du premier exemple de procédé, on peut après l'étape de dépôt de matériau contraint décrite en liaison avec la figure 1D, réaliser ensuite un recuit thermique à une température qui peut être comprise par exemple entre 900 °C et 1100 °C. Ce recuit peut avoir une durée prévue par exemple entre 1s (spike) et 2 min. Le recuit peut être adapté pour modifier la structure de la grille sacrificielle 10a et provoquer une expansion du matériau de grille. Cela peut permettre d'amplifier la contrainte dans la zone 12a destinée à former un canal.

Ensuite, on peut réaliser une étape de polissage CMP du matériau contraint 32.

Selon une possibilité de mise en œuvre particulière du premier exemple de procédé, on peut après l'étape de retrait de la grille sacrificielle décrite en liaison avec la figure 1G, réaliser une séquence d'étapes comprenant la formation d'une nouvelle grille sacrificielle (étape E51 sur figure 7), puis le retrait des blocs de contrainte (étape E52 sur figure 7), puis formation de nouveaux blocs de contrainte (étape E53 sur figure 7), puis retrait de la nouvelle grille sacrificielle (étape E54 sur figure 7), puis recuit éventuel de fluage (étape E55 sur figure 7) du matériau de la couche isolante du substrat.

Cette séquence d'étapes peut être réitérée un nombre N de fois donné pour permettre d'augmenter la contrainte induite dans la zone semi-conductrice 12a.

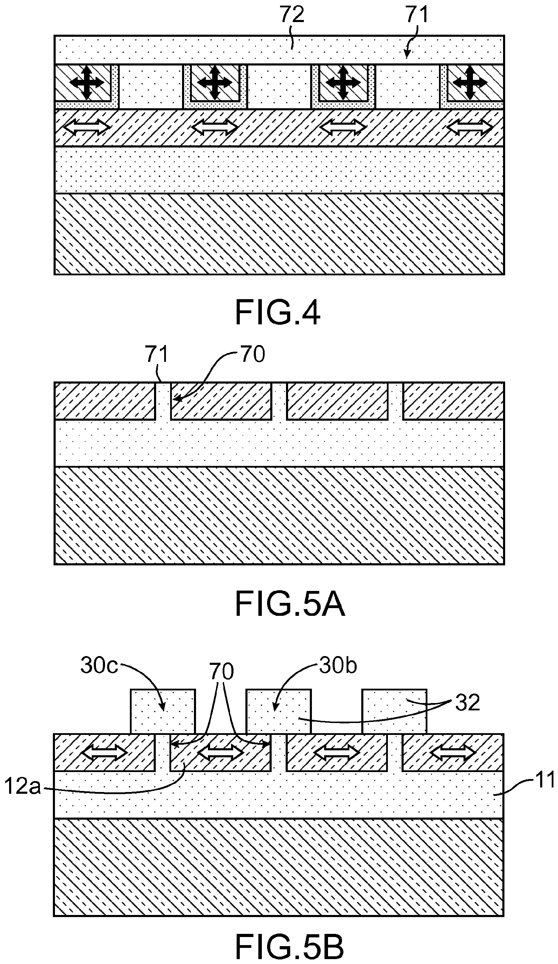

Selon une autre variante de mise en œuvre du premier exemple de procédé, après l'étape de réalisation du bloc de grille 40 décrite précédemment en liaison avec la figure 1I on peut, lorsque le matériau contraint 42 est un diélectrique, effectuer un dépôt d'une autre couche 71 de matériau contraint 42 de manière à recouvrir le bloc 40 de grille et les blocs 32 de matériau contraint. On peut ensuite avantageusement réaliser un recuit thermique tel que décrit précédemment et adapté pour provoquer une expansion du matériau de grille (figure 4). On forme ensuite les espaceurs isolants par gravure du matériau contraint 42.

Selon une autre possibilité de mise en œuvre de l'exemple de procédé qui vient d'être décrit, on peut, après avoir effectué le retrait du matériau contraint décrit en liaison avec les figures 1I-1J, déposer à nouveau un matériau ayant une contrainte élastique intrinsèque, puis effectuer un recuit à haute température, par exemple une température supérieure à 600°C. Ensuite, on retire à nouveau le matériau contraint. Cela peut permettre d'augmenter la contrainte dans la zone semi-conductrice 12a en particulier lorsque celle-ci est contrainte en tension.

Un deuxième exemple de procédé de mise en contrainte d'une zone semi-conductrice de canal de transistor est illustré sur les figures 5A-5D.

Dans cet exemple, le substrat utilisé comme matériau de départ comporte des tranchées 70 remplies de matériau diélectrique 71 formées dans la couche semi-conductrice superficielle 12 (figure 5A et étape E₀ sur la figure 7). Le matériau diélectrique 71 de remplissage peut être le même que celui de la couche isolante 12, par exemple du SiO₂. Les tranchées 70 peuvent permettre de délimiter la zone active du transistor et d'isoler cette zone active de zones actives voisines.

Ensuite (figure 5B), on forme les blocs 30b, 30c de matériau contraint 32 autour d'une zone semi-conductrice 12a dans laquelle le canal du transistor est destiné à être formé.

Les blocs 30b, 30c de matériau contraint 32 sont réalisés par dépôt d'un matériau ayant une contrainte intrinsèque tel que du SiN (étape E'1 sur le diagramme de la figure 7) puis gravure de ce matériau, l'espace entre les blocs étant destiné à accueillir un empilement de grille (étape E'2 sur le diagramme de la figure 7)

Ces blocs 30b, 30c de contrainte peuvent s'étendre de part et d'autre des tranchées 70 sur la zone active du transistor et les zones actives voisines.

Ensuite, une étape de recuit thermique (étape E5 sur la figure 7) de manière à faire fluer le matériau diélectrique 71 de remplissage des tranchées 70 et le matériau de la couche isolante 11 du substrat peut être effectué. Le recuit de fluage peut être réalisé à une température comprise par exemple entre 1000 et 1250 °C pendant une durée par exemple comprise entre 1 à 30 minutes, avantageusement de l'ordre de 30 min. Cette étape peut permettre d'augmenter la contrainte engendrée dans la zone active et en particulier dans la zone semi-conductrice 12a de canal.

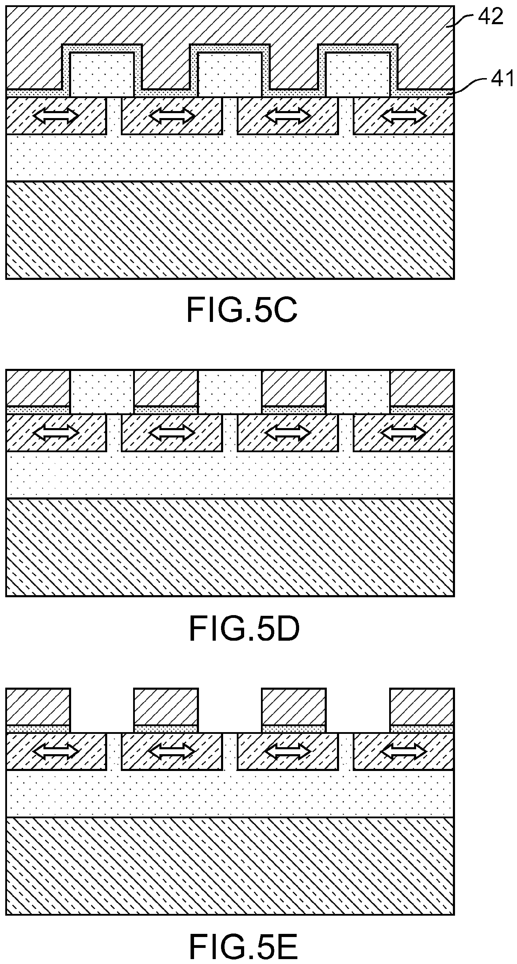

Puis, on forme un empilement de grille 41, 42 sur la zone semi-conductrice 12a de l'empilement comportant le matériau diélectrique 41 de module d'Young élevé, par exemple un matériau diélectrique de type High-k tel que du HfO₂, ou du Al₂O₃ ou du HfSiOₓN_{y} (figure 5C et étape E₆ du diagramme de la figure 7).

On peut ensuite effectuer une planarisation du matériau de grille de manière à former le bloc 40 de grille entre les blocs 30b, 30c de mise en contrainte (figure 5D).

Puis, on retire le matériau 32 contraint (figure 5E et étape E₇ du diagramme de la figure 7).

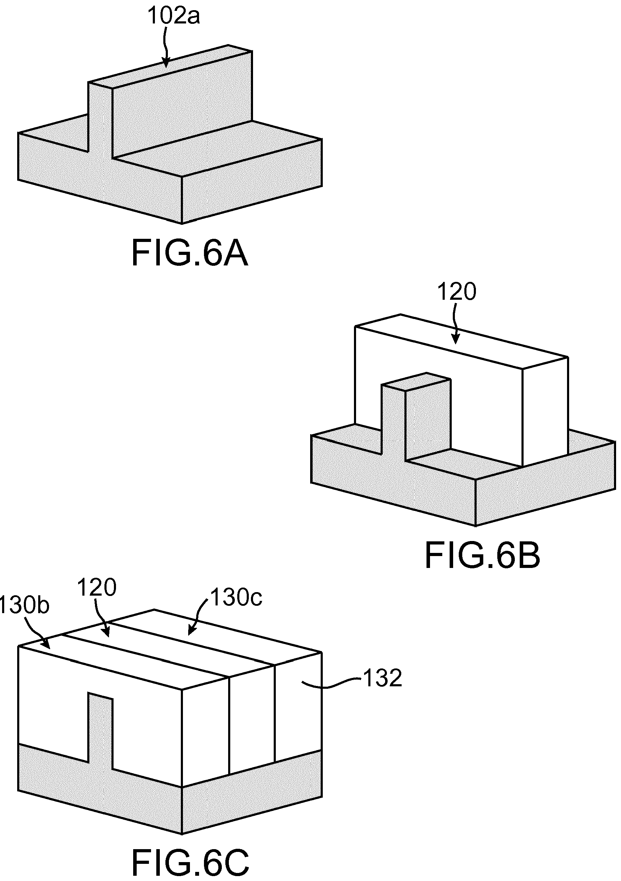

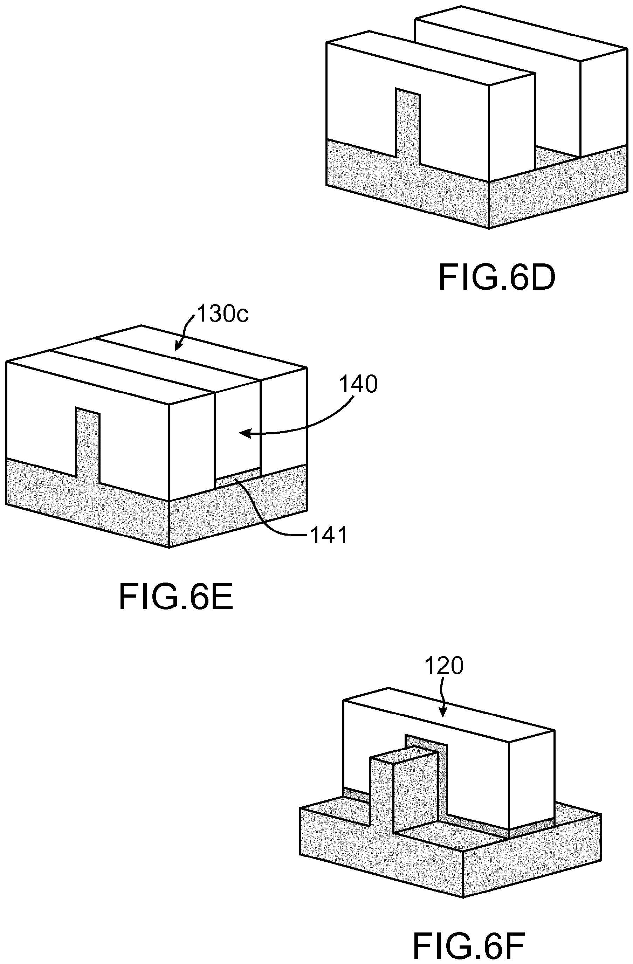

Un autre exemple de procédé prévoit la mise en contrainte d'une zone semi-conductrice de canal d'un transistor de type finFET (figures 6A-6F), la zone semi-conductrice 102a de canal étant cette fois prévue dans un barreau semi-conducteur, par exemple à base de silicium formé dans ou sur la couche superficielle d'un substrat (figure 6A).

On forme ensuite une grille sacrificielle 120 enrobant une portion du barreau semi-conducteur (figure 6B), par exemple par dépôt d'un diélectrique de grille tel que du SiO₂ et d'un matériau de grille tel que du polysilicium.

Puis, des blocs 130b, 130c à base d'un matériau contraint 132, par exemple du nitrure de silicium sont formés contre la grille enrobante (figure 6C). Les blocs 130b, 130c peuvent être par exemple à base de nitrure de silicium et sont agencés de manière à induire une contrainte donnée dans la zone semi-conductrice 102a du barreau semi-conducteur recouverte par la grille sacrificielle 120.

Ensuite, on retire la grille sacrificielle 120 (figure 6D).

Puis, on forme une grille enrobante 140 à l'emplacement où se trouvait la grille sacrificielle. Pour cela, on effectue tout d'abord le dépôt d'un matériau de diélectrique 141 ayant de préférence un module d'Young élevé sur et en contact la zone 102a du barreau semi-conducteur destinée à former un canal. Le matériau diélectrique 141 est avantageusement un matériau *« high-k »* tel que par exemple du HfO₂ ou de l'Al₂O₃ ou du HfSiOₓN_{y}. Ensuite, on dépose un matériau 142 de grille tel que par exemple du polysilicium. La formation de la grille enrobante peut être complétée par une étape de planarisation par CMP.

Ensuite, on retire les blocs 130b, 130c du matériau contraint 132 de part et d'autre du bloc de grille 140 (figure 6F). La contrainte exercée dans la zone semi-conductrice 102a de canal est conservée du fait notamment du matériau diélectrique de grille choisi.

En variante de l'un ou l'autre des exemples qui viennent d'être donnés, on peut avantageusement réaliser le procédé suivant l'invention sur un substrat semi-conducteur sur isolant dont la couche superficielle est à base d'un autre matériau semi-conducteur que le Si, par exemple le Ge ou un matériau de type III-V.

Un procédé selon l'une ou l'autre des variantes décrites précédemment peut être adapté pour contraindre une zone de canal d'un transistor de type N et contraindre une zone de canal d'un transistor de type P formés sur un même substrat.

Dans ce cas, on prévoit des blocs contraints à base d'un matériau tel que par exemple du nitrure compressif de part et d'autre de la grille du transistor P et du nitrure contraint en tension autour de la grille du transistor N.

## Revendications

1. Procédé de réalisation d'un dispositif comprenant au moins une zone semi-conductrice contrainte destinée à former un canal de transistor comprenant, dans cet ordre, des étapes de :
a) formation de plusieurs blocs (30b, 30c, 130b, 130c) de contrainte à base d'un matériau (32, 132) ayant une contrainte intrinsèque autour d'une zone (12a, 102a) à base d'un matériau semi-conducteur dans laquelle un canal d'un transistor est destiné à être réalisé et sur laquelle une grille du transistor est destinée à être formée, les blocs de contrainte étant agencés de manière à induire une contrainte donnée dans cette zone (12a, 102),
b) formation d'un bloc de grille sur cette zone (12a, 102a),
c) retrait au moins partiellement des blocs de contrainte (30b, 30c, 130b, 130c),
le bloc de grille étant formé à l'étape b) avec un module d'Young et une épaisseur de sorte que lorsque les blocs de contrainte sont au moins partiellement retirés à l'étape c), la contrainte donnée est au moins partiellement conservée dans la zone de canal,
le procédé étant **caractérisé en ce qu'**à l'issue de l'étape b), les blocs de contraintes sont agencés contre des flancs latéraux du bloc de grille.

2. Procédé selon la revendication 1, le bloc de grille étant formé par dépôt d'au moins un diélectrique de grille et d'au moins un matériau de grille.

3. Procédé selon la revendication 2, dans lequel le bloc de grille comprend au moins un matériau de diélectrique (41, 141) déposé sur le matériau semi-conducteur, le matériau diélectrique de grille (41, 141) étant choisi de sorte à avoir un module d'Young plus élevé que celui du matériau semi-conducteur de la zone semi-conductrice (12a ,102a).

4. Procédé selon la revendication 3, dans lequel le diélectrique de grille est un matériau de type High-k.

5. Procédé selon la revendication 4, dans lequel le diélectrique de grille est du HfO₂ ou du Al₂O₃ ou du HfSiOₓN_{y}.

6. Procédé selon l'une des revendications 1 à 5, dans lequel préalablement à l'étape a) on forme sur ladite zone semi-conductrice (12a) une grille sacrificielle (20), le ou les blocs de contrainte (30b, 30c) réalisés à l'étape a) étant disposés contre cette grille sacrificielle, le procédé comprenant en outre après l'étape a) et préalablement à l'étape b) une étape consistant à retirer la grille sacrificielle.

7. Procédé selon la revendication 6, dans lequel préalablement à l'étape de retrait de la grille sacrificielle, on effectue un recuit thermique de manière à permettre une expansion de la grille sacrificielle.

8. Procédé selon l'une des revendications 1 à 7, comprenant après l'étape c) des étapes consistant à :
- déposer une couche à base d'un matériau de contrainte ayant une contrainte élastique intrinsèque,
- effectuer un recuit thermique.

9. Procédé selon l'une des revendications 1 à 8, comprenant en outre, après l'étape c) la réalisation d'espaceurs isolants contre des flancs latéraux du bloc de grille.

10. Procédé selon l'une des revendications 1 à 9, dans lequel le matériau de contrainte est un matériau diélectrique, le procédé comprenant la formation d'espaceurs isolants dans le matériau de contrainte diélectrique.

11. Procédé selon l'une des revendication 1 à 10, dans lequel la zone semi-conductrice appartient à une région de la couche superficielle d'un substrat délimitée par une ou plusieurs tranchées (70) remplies de matériau isolant (71) et/ou dans lequel la zone semi-conductrice (12a) repose sur une couche (11) de matériau isolant, le procédé comprenant en outre après l'étape b) une étape de recuit thermique de manière faire fluer le matériau isolant.

12. Procédé selon l'une des revendications 1 à 11, dans lequel la zone semi-conductrice (12a) est située dans une couche superficielle (12) d'un substrat de type semi-conducteur sur isolant et repose sur une couche isolante (11) du substrat semi-conducteur sur isolant, la couche isolante reposant sur une couche de support semi-conductrice (10).

13. Procédé selon l'une des revendications 1 à 12, dans lequel le dispositif comprend un transistor MOSFET de type FinFET, la zone semi-conductrice (102a) étant située dans un barreau semi-conducteur.

14. Procédé de réalisation d'un transistor à canal contraint comprenant un procédé selon l'une des revendications 1 à 13.

## Patentansprüche

1. Verfahren zur Herstellung einer Vorrichtung mit mindestens einem unter Belastung stehenden halbleitenden Bereich, der dazu bestimmt ist, einen Transistorkanal zu bilden, umfassend, in dieser Reihenfolge, folgende Schritte:
a) Bildung mehrerer Belastungsblöcke (30b, 30c, 130b, 130c) auf Basis eines Materials (32, 132) mit einer intrinsischen Belastung um einen Bereich (12a, 102a) auf Basis eines Halbleitermaterials herum, in dem ein Kanal eines Transistors erzeugt werden soll, und auf dem ein Gate des Transistors gebildet werden soll, wobei die Belastungsblöcke so angeordnet sind, dass sie eine gegebene Belastung in diesem Bereich (12a, 102) induzieren,
b) Bildung eines Gate-Blocks auf diesem Bereich (12a, 102a),
c) zumindest teilweise Entfernung der Belastungsblöcke (30b, 30c, 130b, 130c),
wobei der Gate-Block im Schritt b) mit einem Youngschen Modul und einer Dicke ausgebildet wird, so dass dann, wenn die Belastungsblöcke im Schritt c) wenigstens teilweise entfernt werden, die gegebene Belastung in dem Bereich des Kanals zumindest teilweise beibehalten wird, wobei das Verfahren **dadurch gekennzeichnet ist, dass** am Ende des Schritts b) die Belastungsblöcke an den Seitenflächen des Gate-Blocks angeordnet sind.

2. Verfahren nach Anspruch 1, wobei der Gate-Block durch Aufbringen von wenigstens einem Gate-Dielektrikum und wenigstens einem Gate-Material gebildet wird.

3. Verfahren nach Anspruch 2, wobei der Gate-Block mindestens ein auf das Halbleitermaterial aufgebrachtes dielektrisches Material (41, 141) umfasst, wobei das dielektrische Gate-Material (41, 141) so ausgewählt ist, dass es einen Youngschen Modul aufweist, der höher ist als derjenige des Halbleitermaterials des halbleitenden Bereichs (12a, 102a).

4. Verfahren nach Anspruch 3, wobei das Gate-Dielektrikum ein Material vom High-k-Typ ist.

5. Verfahren nach Anspruch 4, bei dem das Gate-Dielektrikum HfO₂ oder Al₂O₃ oder HfSiOₓN_{y} ist.

6. Verfahren nach einem der Ansprüche 1 bis 5, wobei vor dem Schritt a) auf dem halbleitenden Bereich (12a) ein Opfer-Gate (20) gebildet wird, wobei der Belastungsblock oder die Belastungsblöcke (30b, 30c), der oder die im Schritt a) gebildet wird bzw. werden, an diesem Opfer-Gate angeordnet wird bzw. werden, wobei das Verfahren ferner nach dem Schritt a) und vor dem Schritt b) einen Schritt umfasst, bei dem das Opfer-Gate entfernt wird.

7. Verfahren nach Anspruch 6, wobei vor dem Schritt des Entfernens des Opfer-Gates eine thermische Behandlung durchgeführt wird, um eine Ausdehnung des Opfer-Gates zu ermöglichen.

8. Verfahren nach einem der Ansprüche 1 bis 7, umfassend, nach dem Schritt c), Schritte umfassend:
- Aufbringen einer Schicht auf Basis eines Belastungsmaterials mit einer intrinsischen elastischen Belastung,
- Durchführen einer thermischen Behandlung.

9. Verfahren nach einem der Ansprüche 1 bis 8, ferner umfassend, nach dem Schritt c), die Bildung isolierender Abstandshalter an den Seitenflächen des Gate-Blocks.

10. Verfahren nach einem der Ansprüche 1 bis 9, wobei das Belastungsmaterial ein dielektrisches Material ist, wobei das Verfahren das Bilden isolierender Abstandshalter in dem dielektrischen Belastungsmaterial umfasst.

11. Verfahren nach einem der Ansprüche 1 bis 10, wobei der halbleitende Bereich zu einem Bereich der Oberflächenschicht eines Substrats gehört, der durch einen oder mehrere mit isolierendem Material (71) gefüllte Gräben (70) begrenzt ist, oder/und wobei der halbleitende Bereich (12a) auf einer Schicht (11) aus isolierendem Material liegt, wobei das Verfahren ferner nach dem Schritt b) einen Schritt der thermischen Behandlung umfasst, um das isolierende Material zum Fließen/Kriechen zu veranlassen.

12. Verfahren nach einem der Ansprüche 1 bis 11, wobei sich der halbleitende Bereich (12a) in einer Oberflächenschicht (12) eines Substrats vom Typ Halbleiter-auf-Isolator befindet und auf einer isolierenden Schicht (11) des Halbleiter-auf-Isolator-Substrats liegt, wobei die isolierende Schicht auf einer halbleitenden Trägerschicht (10) liegt.

13. Verfahren nach einem der Ansprüche 1 bis 12, wobei die Vorrichtung einen MOSFET-Transistor vom FinFET-Typ umfasst, wobei sich der halbleitende Bereich (102a) in einer Halbleiter-Finne befindet.

14. Verfahren zum Herstellen eines Transistors mit unter Belastung stehendem Kanal, umfassend ein Verfahren nach einem der Ansprüche 1 bis 13.

## Claims

1. Method for making a device comprising at least one strained semiconducting zone that will form a transistor channel comprising the following sequence of steps, in this order:
a) forming one or several stress blocks (30b, 30c, 130b, 130c) based on a material (32, 132) with an intrinsic stress around a zone (12a, 102a) based on a semiconducting material in which a transistor channel will be made and on which a transistor gate will be formed, the stress block(s) being arranged to induce a given stress in this zone (12a, 102),
b) forming a gate block on this zone (12a, 102), the gate block being arranged between the stress blocks,
c) at least partially removing the stress block(s) (30b, 30c, 130b, 130c),
the gate block being chosen in step b) with a Young's modulus and thickness such that the stress blocks are at least partially removed in step c), the given stress is at least partially maintained in the channel zone.

2. Method according to claim 1, the gate block being formed by deposition of at least one gate dielectric and at least one gate material.

3. Method according to claim 2, wherein the gate block comprises at least one dielectric material (41, 141) deposited on the semiconducting material, the gate dielectric material (41, 141) being chosen to have a Young's modulus higher than that of the semiconducting material in the semiconducting zone (12a, 102).

4. Method according to claim 3, wherein the gate dielectric is a High-k type material.

5. Method according to claim 4, wherein the gate dielectric is HfO₂ or Al₂O₃ or HfSiOₓN_{y}.

6. Method according to any of the claims 1 to 5, wherein a sacrificial gate is formed on said semiconducting zone (12a) before step a), the stress block(s) (30b, 30c) made in step a) being arranged in contact with this sacrificial gate (20), the method also comprising a step to remove the sacrificial gate, after step a) and before step b).

7. Method according to claim 6, wherein thermal annealing is made before removal of the sacrificial gate, particularly at high temperature, to enable expansion of the sacrificial gate.

8. Method according to any of the claims 1 to 7, comprising additional steps after step c) to:
- deposit a layer based on a stress material with an intrinsic elastic stress,
- perform thermal annealing.

9. Method according to claim any of the claims 1 to 8, further comprising the formation of insulating spacers in contact with the lateral flanks of the gate block, after step c).

10. Method according to any of the claims 1 to 9, wherein the stress material is a dielectric material, the method comprising the formation of insulating spacers in the dielectric stress material.

11. Method according to any of the claims 1 to 10, in which the semiconducting zone forms part of a region of the surface layer delimited by one or several trenches (70) filled with an insulating material (71) and/or in which the semiconducting zone (12a) is supported on a layer (11) of insulating material, the method also comprising a thermal annealing step to make the insulating material creep, after step b).

12. Method according to any of the claims 1 to 11, in which the semiconducting zone (12a) is located in a surface layer (12) of a semiconductor on insulator type substrate and is supported on an insulating layer (11) of the semiconductor on insulator substrate, the insulating layer being supported on a semiconducting layer (10).

13. Method according to any of the claims 1 to 12, in which the MOSFET transistor is a FinFET type transistor, the semiconducting zone (102a) being located in a semiconducting bar.

14. Method of making a strained channel transistor comprising a method according to any of the claims 1 to 13.
